# FASCICULE DE BREVET EUROPEEN

(11) **EP 3 267 583 B1**
(45) Date de publication et mention de la délivrance du brevet: **24.03.2021**
(21) Numéro de dépôt: 17176497.0
(22) Date de dépôt: 16.06.2017
(51) Int. Cl.: H03K 17/693, H02J 1/10

(54) **CIRCUIT DE SÉLECTION D'UNE TENSION D'ALIMENTATION À TRANSITION CONTRÔLÉE**
AUSWAHLSCHALTKREIS EINER BETRIEBSSPANNUNG MIT KONTOLLIERTEM ÜBERGANG
CIRCUIT FOR SELECTING A SUPPLY VOLTAGE WITH CONTROLLED TRANSITION

(30) Priorité: 07.07.2016 FR 1656566
(43) Date de publication de la demande: 10.01.2018
(73) Titulaire: Commissariat à l'Energie Atomique et aux Energies Alternatives, 75015 Paris (FR)
(72) Inventeur: QUELEN, Anthony, 38180 SEYSSINS (FR)
(74) Mandataire: Cabinet Beaumont

(56) Documents cités:
- EP-A2- 2 388 881
- US-A1- 2010 164 460
- US-B1- 6 891 425
- SYLVAIN MIERMONT ET AL: "A Power Supply Selector for Energy and Area-Efficient Local Dynamic Voltage Scaling", 3 September 2007 (2007-09-03), TED CIRCUIT AND SYSTEM DESIGN : POWER AND TIMING MODELING, OPTIMIZATION AND SIMULATION : 17TH INTERNATIONAL WORKSHOP, PATMOS 2007, GOTHENBURG, SWEDEN, SEPTEMBER 3-5, 2007 ; PROCEEDINGS; [LECTURE NOTES IN COMPUTER SCIENCE], SPRINGER, BERLIN, HEIDELBER, XP019098355, ISBN: 978-3-540-74441-2 * paragraph [03.1]; figure 2 *

## Description

### Domaine

La présente demande concerne le domaine des circuits électroniques de façon générale, et vise plus particulièrement un circuit de sélection d'une tension d'alimentation, par exemple pour circuit intégré.

### Exposé de l'art antérieur

Dans certains dispositifs électroniques, on souhaite pouvoir modifier le niveau de la tension d'alimentation d'un circuit intégré, par exemple pour optimiser la gestion de l'énergie électrique dans le dispositif. De préférence, cette modification du niveau de la tension d'alimentation doit pouvoir se faire de façon dynamique, c'est-à-dire sans interrompre le fonctionnement du circuit intégré.

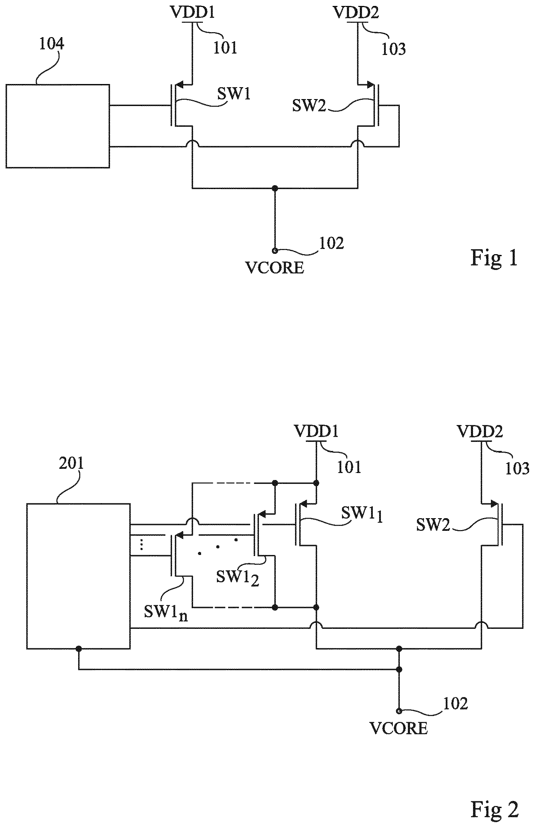

La figure 1 est un schéma électrique simplifié d'un exemple d'un circuit de sélection d'une tension d'alimentation. Le circuit de la figure 1 comprend deux transistors MOS de puissance SW1 et SW2. Le transistor SW1 relie, via ses noeuds de conduction (source et drain), un noeud 101 d'application d'une première tension d'alimentation d'entrée VDD1 à un noeud 102 de fourniture d'une tension d'alimentation de sortie VCORE. Le transistor SW2 relie, via ses noeuds de conduction, un noeud 103 d'application d'une deuxième tension d'alimentation d'entrée VDD2 inférieure à la tension VDD1 au noeud VCORE. Le circuit de sélection de tension de la figure 1 comprend en outre un circuit de contrôle 104 connecté aux grilles des transistors SW1 et SW2, configurable pour, dans une première configuration, maintenir les transistors SW1 et SW2 respectivement fermé (passant) et ouvert (bloqué), et, dans une deuxième configuration, maintenir les transistors SW1 et SW2 respectivement ouvert et fermé. Dans la première configuration, la tension VCORE sur le noeud 102 est sensiblement égale à la tension VDD1, et, dans la deuxième configuration, la tension VCORE sur le noeud 102 est sensiblement égale à la tension VDD2. Le noeud 102 est destiné à être connecté à un noeud d'alimentation d'une charge (non représentée), par exemple un circuit intégré. Ainsi, le circuit de la figure 1 permet, par l'intermédiaire de son circuit de contrôle 104, de sélectionner l'une ou l'autre des tensions VDD1 et VDD2 pour l'alimentation du circuit charge.

Un problème qui se pose dans un tel circuit de sélection de tension est celui du contrôle des transitions entre les première et deuxième configurations. En particulier, pour limiter les pertes énergétiques, les transistors SW1 et SW2 sont généralement choisis pour présenter des résistances série faibles à l'état passant. Ainsi, si les deux transistors SW1 et SW2 se trouvent fermés simultanément, même pendant un court instant, un fort courant circule entre les noeuds 101 et 103, ce qui peut conduire à des dégradations. En outre, si les deux transistors SW1 et SW2 se trouvent ouverts simultanément, même pendant un court instant, une chute de tension peut se produire sur le noeud 102, ce qui peut conduire à des dysfonctionnements du circuit charge.

La figure 2 est un schéma électrique simplifié illustrant un exemple d'architecture de circuit de sélection de tension d'alimentation qui a été proposé pour tenter de résoudre ce problème.

Dans cet exemple, on considère que la tension d'alimentation d'entrée VDD1 appliquée sur le noeud 101 est supérieure à la tension d'alimentation d'entrée VDD2 appliquée sur le noeud 103. Dans le circuit de la figure 2, le transistor SW1 de la figure 1 est remplacé par une pluralité de transistors élémentaires SW1ᵢ de plus petites dimensions (et donc ayant une résistance série à l'état passant plus élevée) connectés en parallèle entre les noeuds 101 et 102 (avec i entier allant de 1 à n et n entier supérieur à 1). Les grilles des transistors élémentaires SW1ᵢ et du transistor SW2 sont connectées à un circuit de contrôle numérique 201. Les transistors élémentaires SW1ᵢ sont commandables individuellement à l'état ouvert ou à l'état fermé par le circuit de contrôle 201. Le circuit de contrôle 201 est configurable pour, dans une première configuration, maintenir l'ensemble des transistors SW1ᵢ fermés et le transistor SW2 ouvert de façon à appliquer la tension VDD1 sur le noeud 102, et, dans une deuxième configuration, maintenir l'ensemble des transistors SW1ᵢ ouverts et le transistor SW2 fermé de façon à appliquer la tension VDD2 sur le noeud 102. Le circuit de contrôle 201 est en outre connecté au noeud VCORE et comprend une boucle numérique de rétroaction permettant, pendant des phases de transition entre les première et deuxième configurations, de fermer/ouvrir un par un les transistors SW1ᵢ pour contrôler la vitesse de croissance/décroissance de la tension VCORE sur le noeud 102.

Des exemples d'architectures de ce type sont notamment décrits dans les publications intitulées "A Power Supply Selector for Energy- and Area-Efficient Local Dynamic Voltage Scaling" (Sylvain Miermont, PATMOS 2007, LNCS 4644, pp. 556-565), "Advanced Control Design for Voltage Scaling Converters" (Carolina Albea, Industrial Electronics, 2008. IECON 2008. 34th Annual Conférence of IEEE), "High Performance Control Design for Dynamic Voltage Scaling Devices" (Carolina Albea, IEEE TRANSACTIONS ON CIRCUITS AND SYSTEMS-I: REGULAR PAPERS, VOL. 58, NO. 12, DECEMBER 2011), et "Robust Saturated Control for Low-Power Circuits" (Carolina Albea, IEEE TRANSACTIONS ON CONTROL SYSTEMS TECHNOLOGY, VOL. 21, NO. 2, MARCH 2013).

Un inconvénient de ce type d'architecture réside dans la nécessité de fournir au circuit de contrôle un signal d'horloge (non représenté) de fréquence relativement élevée (typiquement plusieurs centaines de MHz), ce qui entraine une consommation électrique élevée pendant les phases de transition entre les première et deuxième configurations. En outre, pendant les phases de transition entre les première et deuxième configurations, il peut se produire une ondulation de la tension VCORE sur le noeud 102, induite par la boucle numérique de régulation. De plus, ce type d'architecture ne permet pas d'éviter totalement des chutes de la tension VCORE sur le noeud 102, ni la circulation de courants élevés entre les noeuds 101 et 103, pendant les phases de transition entre les première et deuxième configurations. Par ailleurs, ce type d'architecture peut être sujet à des dysfonctionnements si le courant de charge tiré sur le noeud 102 par le circuit charge est trop élevé ou fluctue pendant les phases de transition entre les première et deuxième configurations.

Les documents US6891425 et US2010/164460 décrivent des exemples de circuits de sélection de tension d'alimentation. Il serait souhaitable de pouvoir disposer d'un circuit de sélection d'une tension d'alimentation, ce circuit palliant tout ou partie des inconvénients des circuits existants.

### Résumé

Ainsi, un mode de réalisation prévoit un circuit de sélection d'une tension d'alimentation, comprenant : des premier et deuxième noeuds adaptés à recevoir respectivement des première et deuxième tensions d'alimentation d'entrée ; un troisième noeud adapté à fournir une tension d'alimentation de sortie ; un premier transistor MOS de puissance reliant le premier noeud au troisième noeud ; un deuxième transistor MOS de puissance reliant le deuxième noeud au troisième noeud ; et un circuit de contrôle adapté, dans une première configuration, à maintenir les premier et deuxième transistors respectivement fermé et ouvert, et, dans une deuxième configuration, à maintenir les premier et deuxième transistors respectivement ouvert et fermé, le circuit de contrôle comportant une boucle de rétroaction du troisième noeud vers la grille du premier transistor, et étant adapté, lors d'une phase de transition de la première à la deuxième configuration ou de la deuxième à la première configuration, à commander le premier transistor en régime linéaire pour appliquer une rampe de tension continue sur le troisième noeud, dans lequel le circuit de contrôle comprend : un générateur de rampes de tension ; et un premier circuit de régulation linéaire dont un premier noeud d'entrée est connecté au troisième noeud, dont un deuxième noeud d'entrée est connecté à un noeud de sortie du générateur de rampes, et dont un noeud de sortie est connecté à la grille du premier transistor et dans lequel le premier circuit de régulation linéaire est adapté à ajuster un signal de commande appliqué, via son noeud de sortie, sur la grille du premier transistor, de façon à asservir la tension de sortie sur une tension de consigne appliquée sur son deuxième noeud d'entrée.

Selon un mode de réalisation, le circuit de sélection comporte en outre un deuxième circuit de régulation linéaire dont un premier noeud d'entrée est connecté au troisième noeud, dont un deuxième noeud d'entrée est connecté à un noeud de sortie du générateur de rampes, et dont un noeud de sortie est connecté à la grille du deuxième transistor.

Selon un mode de réalisation, le circuit de sélection comprend en outre un circuit de détection d'une inversion du courant circulant dans le deuxième transistor.

Selon un mode de réalisation, le circuit de détection comprend un transistor de mesure agencé pour être traversé par un courant de mesure proportionnel au courant traversant le deuxième transistor, et un comparateur de courant adapté à comparer ledit courant de mesure à un seuil.

Selon un mode de réalisation, le circuit de sélection comprend en outre un circuit de comparaison de la tension de sortie à un seuil.

Selon un mode de réalisation, le circuit de sélection, comporte en outre un circuit de génération d'un retard prédéterminé.

Selon un mode de réalisation, le premier transistor MOS de puissance est relié au premier noeud par l'intermédiaire d'un premier transistor MOS supplémentaire présentant des courants de fuite à l'état bloqué inférieurs à celui du premier transistor MOS de puissance, et dans lequel le deuxième transistor MOS de puissance est relié au deuxième noeud par l'intermédiaire d'un deuxième transistor MOS supplémentaire présentant des courants de fuite à l'état bloqué inférieurs à celui du deuxième transistor MOS de puissance.

Selon un mode de réalisation, le circuit de contrôle est adapté, dans une troisième configuration, à maintenir les premier et deuxième transistors MOS de puissance et les premier et deuxième transistors MOS supplémentaires à l'état ouvert.

Selon un mode de réalisation, la première tension d'alimentation d'entrée est supérieure à la deuxième tension d'alimentation d'entrée, le circuit de contrôle étant adapté, lors d'une phase de transition descendante entre les première et deuxième configurations, à : commander le premier transistor en régime linéaire pour appliquer une rampe de tension continue décroissante sur le troisième noeud ; détecter un passage de la tension de sortie à un niveau sensiblement égal à celui de la deuxième tension d'alimentation d'entrée ; et lorsque la tension de sortie atteint un niveau sensiblement égal à celui de la deuxième tension d'alimentation d'entrée, fermer le deuxième transistor MOS de puissance et ouvrir le premier transistor MOS de puissance.

Selon un mode de réalisation, la première tension d'alimentation d'entrée est supérieure à la deuxième tension d'alimentation d'entrée, le circuit de contrôle étant adapté, lors d'une phase de transition montante entre les première et deuxième configurations, à : commander, le premier transistor en régime linéaire pour appliquer une rampe de tension continue croissante sur le troisième noeud ; détecter une inversion du courant circulant dans le deuxième transistor ; lorsque le courant circulant dans le deuxième transistor s'inverse, ouvrir le deuxième transistor ; et après un délai prédéterminé, fermer le premier transistor MOS de puissance.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1, précédemment décrite est un schéma électrique simplifié d'un exemple d'un circuit de sélection d'une tension d'alimentation ;
la figure 2, précédemment décrite, est un schéma électrique simplifié d'un autre exemple d'un circuit de sélection d'une tension d'alimentation ;
la figure 3 est un schéma électrique d'un exemple d'un circuit de sélection d'une tension d'alimentation selon un mode de réalisation ;
les figures 4 et 5 sont des chronogrammes illustrant un exemple d'un mode de fonctionnement du circuit de la figure 3 ;
la figure 6 est un schéma électrique d'un exemple de réalisation d'un circuit de régulation linéaire de tension du circuit de la figure 3 ; et
la figure 7 est un schéma électrique d'un autre exemple de réalisation d'un circuit de régulation linéaire de tension du circuit de la figure 3.

### Description détaillée

De mêmes éléments ont été désignés par de mêmes références aux différentes figures et, de plus, les diverses figures ne sont pas tracées à l'échelle. Par souci de clarté, seuls les éléments qui sont utiles à la compréhension des modes de réalisation décrits ont été représentés et sont détaillés. En particulier, les diverses utilisations qui peuvent être faites des circuits de sélection de tension d'alimentation décrits n'ont pas été détaillées, les modes de réalisation décrits étant compatibles avec les applications usuelles de circuits de sélection de tension d'alimentation. Sauf précision contraire, les expressions "approximativement", "sensiblement", et "de l'ordre de" signifient à 10 % près, de préférence à 5 % près. Par ailleurs, on utilise le terme "connecté" pour désigner une liaison électrique directe, sans composant électronique intermédiaire, par exemple au moyen d'une ou plusieurs pistes conductrices ou fils conducteurs, et le terme "couplé" ou le terme "relié", pour désigner une liaison électrique qui peut être directe (signifiant alors "connecté") ou indirecte (c'est-à-dire via un ou plusieurs composants intermédiaires).

Selon un aspect d'un mode de réalisation, on prévoit un circuit de sélection de tension d'alimentation du type décrit en relation avec la figure 1, mais dans lequel les transistors SW1 et/ou SW2 sont commandés en régime linéaire pendant les phases de transition entre les première et deuxième configurations, de façon à contrôler la variation de la tension VCORE sur le noeud 102.

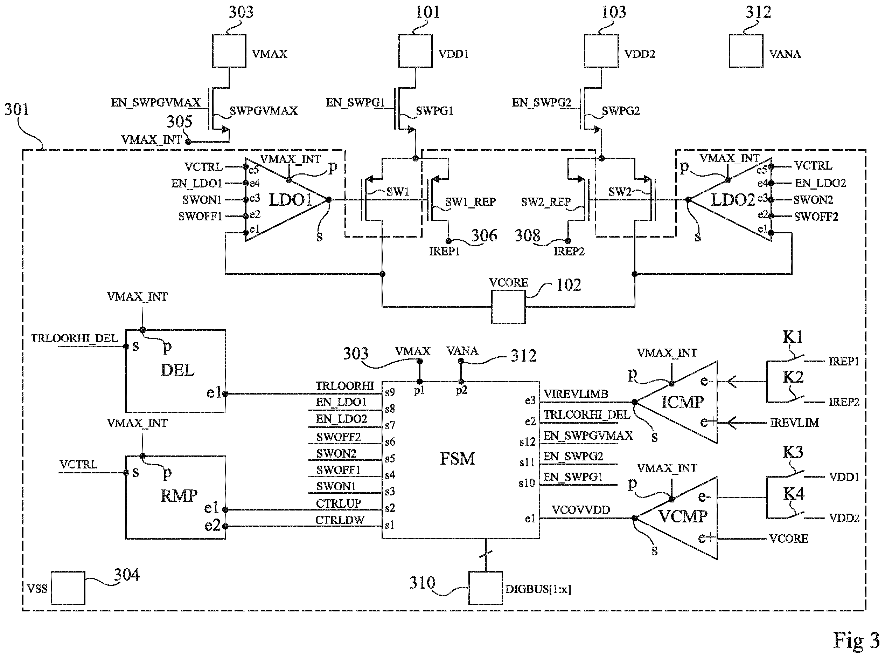

La figure 3 est un schéma électrique d'un exemple d'un circuit de sélection d'une tension d'alimentation selon un mode de réalisation.

Le circuit de la figure 3 comprend deux transistors MOS de puissance SW1 et SW2. Le transistor SW1 relie, via ses noeuds de conduction (source et drain), un noeud ou une borne 101 d'application d'une première tension d'alimentation d'entrée continue VDD1 à un noeud ou une borne 102 de fourniture d'une tension d'alimentation de sortie continue VCORE, et le transistor SW2 relie, via ses noeuds de conduction, un noeud ou une borne 103 d'application d'une deuxième tension d'alimentation d'entrée continue VDD2 au noeud 102 de fourniture de la tension VCORE. Dans l'exemple de la figure 3, le noeud de conduction du transistor SW1, respectivement SW2, opposé au noeud 102 n'est pas connecté directement au noeud 101, respectivement 103, mais est relié au noeud 101, respectivement 103 par l'intermédiaire d'un transistor MOS SWPG1, respectivement SWPG2. Dans l'exemple représenté, les transistors SW1 et SW2 sont des transistors MOS à canal P, et les transistors SWPG1 et SWPG2 sont des transistors MOS à canal N. Les transistors SW1 et SW2 ont leurs drains connectés au noeud 102, et leurs sources connectées respectivement à la source du transistor SWPG1 et à la source du transistor SWPG2. Les transistors SWPG1 et SWPG2 ont leurs drains connectés respectivement au noeud 101 et au noeud 102.

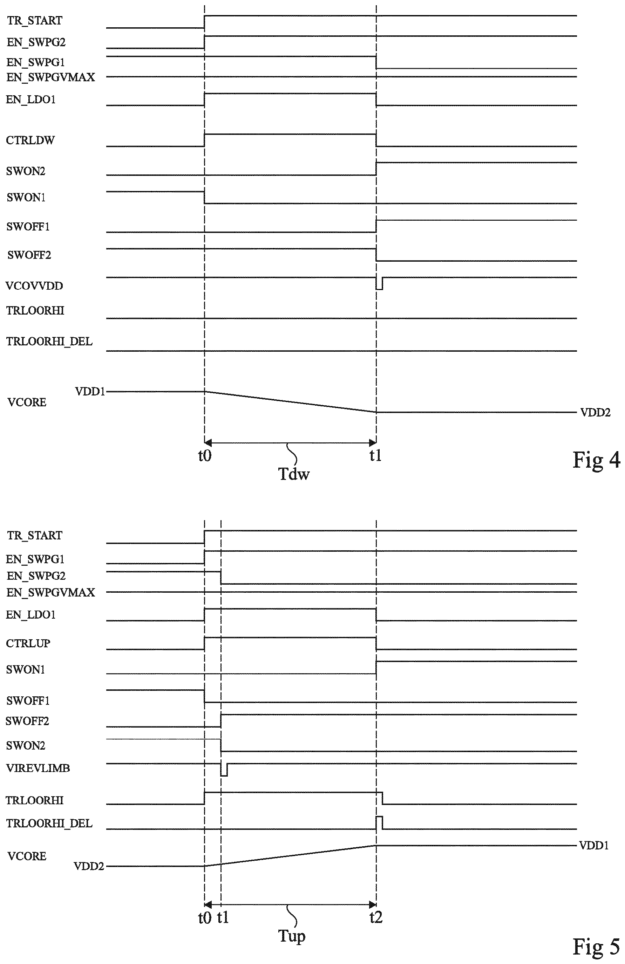

Le circuit de sélection de tension de la figure 3 comprend en outre un circuit de contrôle 301 connecté aux grilles des transistors SW1 et SW2, configurable pour, dans une première configuration, maintenir les transistors SW1 et SW2 respectivement fermé et ouvert, et, dans une deuxième configuration, maintenir les transistors SW1 et SW2 respectivement ouvert et fermé. Dans la première configuration, la tension VCORE sur le noeud 102 est sensiblement égale à la tension VDD1, et, dans la deuxième configuration, la tension VCORE sur le noeud 102 est sensiblement égale à la tension VDD2. On notera que, en fonctionnement, les transistors SWPG1, respectivement SWPG2, sont maintenus fermés lorsque les transistors SW1, respectivement SW2, sont commandés à l'état passant. Comme cela sera expliqué plus en détail en relation avec les figures 4 et 5, les transistors SWPG1, SWPG2 servent uniquement à limiter les fuites à travers les transistors SW1, SW2 lorsque ces derniers sont à l'état bloqué. A titre d'exemple, lorsque le circuit de sélection n'est pas utilisé, c'est-à-dire lorsqu'aucune des tensions d'alimentation d'entrée VDD1, VDD2 n'est sélectionnée pour alimenter le noeud 102, les transistors SW1, SW2 sont mis à l'état ouvert, et les transistors SWPG1 et SWPG peuvent être maintenus à l'état ouvert de façon à limiter les fuites vers la masse à travers notamment les transistors SW1 et SW2.

Le circuit de contrôle 301 comporte une boucle de rétroaction analogique du noeud 102 vers la grille du transistor SW1, et une boucle de rétroaction analogique du noeud 102 vers la grille du transistor SW2. Le circuit 301 est adapté, lors des phases de transition de la première à la deuxième configuration ou de la deuxième à la première configuration, à commander le transistor SW1 ou le transistor SW2 en régime linéaire pour appliquer une rampe de tension prédéterminée sur le noeud 102, et ainsi contrôler l'évolution de la tension VCORE.

Dans l'exemple de la figure 3, le circuit de sélection de tension est prévu pour pouvoir fonctionner indifféremment que la tension d'alimentation d'entrée VDD1 appliquée sur le noeud 101 soit supérieure ou inférieure à la tension d'alimentation d'entrée VDD2 appliquée sur le noeud 103. Ceci permet une plus grande souplesse d'utilisation, notamment lors du montage du circuit dans un dispositif électronique. Comme cela sera expliqué plus en détail ci-après, le circuit peut toutefois être simplifié lorsque l'on sait à l'avance laquelle des tensions d'alimentation d'entrée VDD1 et VDD2 est la plus élevée.

Le circuit de sélection de tension de la figure 3 comprend un noeud ou une borne 303 destiné, en fonctionnement, à recevoir une tension d'alimentation VMAX sensiblement égale à la plus élevée des deux tensions d'alimentation d'entrée VDD1 et VDD2. Dans l'exemple représenté, le noeud 303 est relié à un noeud 305 de fourniture d'une tension d'alimentation interne VMAX INT par l'intermédiaire d'un transistor MOS SWPGVMAX. Dans l'exemple représenté, le transistor SWPGVMAX est un transistor MOS à canal N dont le drain est connecté au noeud 303 et dont la source est connectée au noeud 305. Le circuit de sélection de tension de la figure 3 comprend en outre un noeud ou une borne 304 destiné à recevoir un potentiel de référence VSS, par exemple la masse, auquel sont référencées toutes les tensions du circuit.

Dans l'exemple de la figure 3, les transistors SWPG1, SWPG2, SWPGVMAX ont pour fonction de limiter les courants de fuite dans le circuit de sélection de tension. En particulier, les transistors SWPG1, SWPG2 sont choisis pour présenter des fuites à l'état bloqué inférieures à celles des transistors SW1, SW2. Les transistors SWPG1, SWPG2, SWPGVMAX sont par exemple identiques aux dispersions de fabrication près. Ces transistors sont par exemple plus résistifs que les transistors SW1, SW2. Il peut alors être avantageux, pour piloter les transistors SWPG1, SWPG2, SWPGVMAX, d'appliquer sur leurs grilles des tensions de commande EN_SWPG1, EN_SWPG2, EN_SWPGVMAX de niveau supérieur à la tension d'alimentation VMAX du circuit. Pour cela, dans l'exemple de la figure 3, le circuit de sélection de tension comprend en outre un noeud ou une borne 312 d'application d'une tension d'alimentation continue VANA supérieure à la tension VMAX. A titre d'exemple, les transistors SW1, SW2 sont plus rapides que les transistors SWPG1, SWPG2, SWPGVMAX. Les transistors SW1, SW2 ont par exemple un oxyde de grille plus mince que les transistors SWPG1, SWPG2, SWPGVMAX. A titre d'exemple, le transistor SWPGVMAX peut être commandé à l'état ouvert lorsque le circuit de sélection n'est pas utilisé, c'est-à-dire lorsqu'aucune des tensions d'alimentation d'entrée VDD1, VDD2 n'est sélectionnée pour alimenter le noeud 102, de façon à limiter les fuites vers la masse.

Le circuit de contrôle 301 comprend un circuit de régulation linéaire LDO1 dont un noeud d'entrée e1 est connecté au noeud 102 et dont un noeud de sortie s est connecté à la grille du transistor SW1. Le circuit LDO1 forme une boucle de rétroaction analogique adaptée à commander le transistor SW1 en régime linéaire pour contrôler la tension VCORE fournie sur le noeud 102. Dans l'exemple représenté, le circuit de régulation LDO1 comprend un noeud d'entrée e5 destiné à recevoir une tension de consigne VCTRL à reporter sur le noeud 102. Le circuit LDO1 est adapté à ajuster le signal de commande appliqué, via son noeud s, sur la grille du transistor SW1, de façon à asservir la tension VCORE sur la tension de consigne VCTRL. Dans cet exemple, le circuit de régulation LDO1 comprend en outre un noeud d'entrée e4 destiné à recevoir un signal EN_LDO1 d'activation en régulation du circuit LDO1, un noeud d'entrée e3 destiné à recevoir un signal SWON1 de commande à l'état fermé (passant) du transistor SW1, et un noeud d'entrée e2 destiné à recevoir un signal SWOFF1 de commande à l'état ouvert (bloqué) du transistor SW1. Le circuit de régulation LDO1 comprend en outre un noeud d'alimentation p relié au noeud 305 de fourniture de la tension d'alimentation interne VMAX_INT.

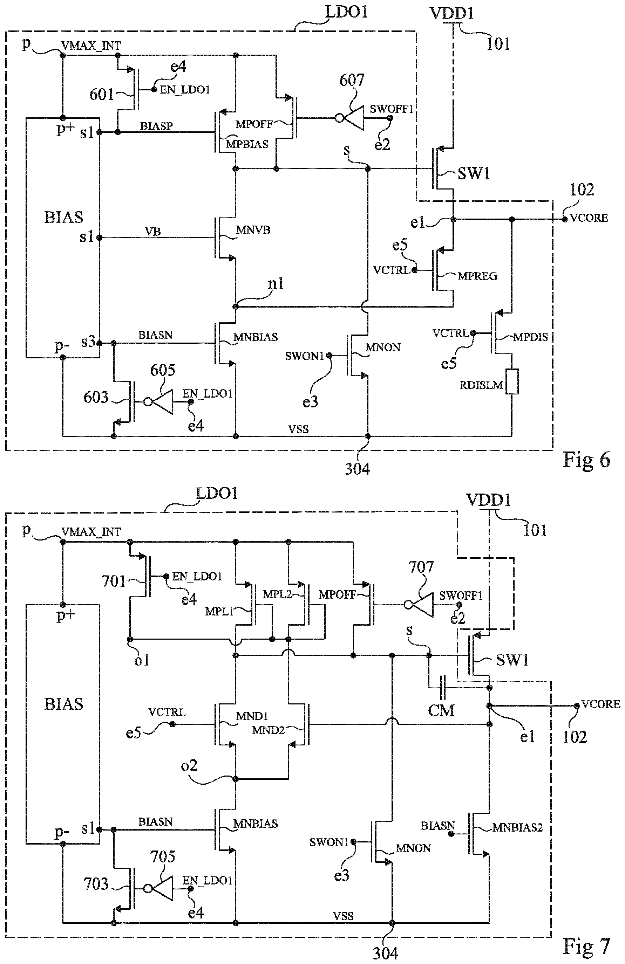

Le circuit de contrôle 301 comprend en outre un circuit de régulation linéaire LDO2 dont un noeud d'entrée e1 est connecté au noeud 102 et dont un noeud de sortie s est connecté à la grille du transistor SW2. Le circuit LDO2 forme une boucle de rétroaction adaptée à commander le transistor SW2 en régime linéaire pour contrôler la tension VCORE fournie sur le noeud 102. Dans l'exemple représenté, le circuit de régulation LDO2 comprend un noeud d'entrée e5 destiné à recevoir une tension de consigne VCTRL à reporter sur le noeud 102. Le circuit LDO2 est adapté à ajuster le signal de commande appliqué, via son noeud s, sur la grille du transistor SW2, de façon à asservir la tension VCORE sur la tension de consigne VCTRL. Dans cet exemple, le circuit de régulation LDO2 comprend en outre un noeud d'entrée e4 destiné à recevoir un signal EN_LDO2 d'activation en régulation du circuit LDO2, un noeud d'entrée e3 destiné à recevoir un signal SWON2 de commande à l'état fermé (passant) du transistor SW2, et un noeud d'entrée e2 destiné à recevoir un signal SWOFF2 de commande à l'état ouvert (bloqué) du transistor SW2. Le circuit de régulation LDO2 comprend en outre un noeud d'alimentation p relié au noeud 305 de fourniture de la tension d'alimentation interne VMAX_INT. Le circuit de régulation LDO2 est par exemple identique ou similaire au circuit de régulation LDO1. Des exemples de réalisation des circuits de régulation linéaire LDO1, LDO2 seront détaillés ci-après en relation avec les figures 6 et 7.

Le circuit de contrôle 301 comprend de plus un circuit RMP de génération de rampes de tension. Le circuit RMP comprend un noeud de sortie s relié aux noeuds d'entrée e5 des circuits de régulation linéaire LDO1 et LDO2 et fournissant la tension de consigne VCTRL appliquée aux circuits LDO1 et LDO2. Dans l'exemple représenté, le circuit RMP comprend un noeud d'entrée e1 destiné à recevoir un signal de commande CTRLUP et un noeud d'entrée e2 destiné à recevoir un signal de commande CTRLDW. Le circuit RMP est adapté, lorsque le signal de commande CTRLUP est activé, à générer sur son noeud s une rampe de tension croissante prédéterminée allant de la plus basse des tensions VDD1 et VDD2 à la plus haute des tensions VDD1 et VDD2, et, lorsque le signal de commande CTRLDW est activé, à générer sur son noeud s une rampe de tension décroissante prédéterminée allant de la plus haute des tensions VDD1 et VDD2 à la plus basse des tensions VDD1 et VDD2. Le circuit RMP comprend en outre un noeud d'alimentation p relié au noeud 305 de fourniture de la tension d'alimentation interne VMAX INT. La réalisation du circuit de génération de rampes de tension RMP n'a pas été détaillée, les modes de réalisation décrits étant compatibles avec tous ou la plupart des circuits de génération de rampes de tension connus.

Le circuit de contrôle 301 comprend par ailleurs un circuit DEL de génération d'un retard prédéterminé. Le circuit DEL comprend un noeud d'entrée e1 destiné à recevoir un signal TRLOORHI, et un noeud de sortie s. Le circuit DEL est adapté à fournir, sur son noeud de sortie s, un signal TRLOORHI_DEL image retardée du signal d'entrée TRLOORHI. Plus particulièrement, le circuit DEL est adapté à reproduire sur sa sortie s, avec un retard prédéterminé, un changement d'état du signal TRLOORHI appliqué sur son noeud d'entrée e1. Le circuit DEL comprend en outre un noeud d'alimentation p relié au noeud 305 de fourniture de la tension d'alimentation interne VMAX_INT. La réalisation du circuit de génération de retard DEL n'a pas été détaillée, les modes de réalisation décrits étant compatibles avec tous ou la plupart des circuits de génération de retard connus.

Le circuit de contrôle 301 de la figure 3 comprend de plus un transistor MOS SW1_REP dont la grille est connectée à la grille du transistor SW1 et dont les noeuds de conduction sont connectés respectivement au noeud de conduction commun entre les transistors SW1 et SWPG1 et à un noeud 306 et un transistor MOS SW2_REP dont la grille est connectée à la grille du transistor SW2 et dont les noeuds de conduction sont connectés respectivement au noeud de conduction commun entre les transistors SW2 et SWPG2 et à un noeud 308. En fonctionnement, le noeud 306 fournit un courant IREP1 sensiblement proportionnel au courant circulant dans le transistor SW1, et le noeud 308 fournit un courant IREP2 sensiblement proportionnel au courant circulant dans le transistor SW2. Les transistors SW1_REP, respectivement SW2_REP sont par exemple des images réduites des transistors SW1, respectivement SW2, c'est-à-dire qu'ils présentent sensiblement les mêmes caractéristiques que les transistors SW1, respectivement SW2, à l'exception de leur largeur de canal, inférieure à celle des transistors SW1, respectivement SW2, et donc de leur résistance source-drain à l'état passant, plus élevée que celle des transistors SW1, respectivement SW2. Les transistors SW1_REP et SW2_REP sont choisis de façon que les coefficients de proportionnalité entre le courant IREP1 et le courant circulant dans le transistor SW1 d'une part, et entre le courant IREP2 et le courant circulant dans le transistor SW2 d'autre part, soient sensiblement égaux. Les transistors SW1_REP et SW2_REP sont par exemple sensiblement identiques. Dans l'exemple représenté, les transistors SW1_REP, respectivement SW2_REP sont des transistors MOS à canal P dont les sources sont connectées aux sources des transistors SW1, respectivement SW2, et dont les drains sont connectés aux noeuds 306, respectivement 308.

Le circuit de contrôle 301 de la figure 3 comprend de plus un comparateur de courant ICMP dont un premier noeud d'entrée e- est relié d'une part au noeud 306 de fourniture du courant IREP1 par un premier interrupteur K1, et d'autre part au noeud 308 de fourniture du courant IREP2 par un deuxième interrupteur K2, et dont un deuxième noeud d'entrée e+ est destiné à recevoir un courant de référence IREVLIM. Le comparateur de courant ICMP comprend un noeud de sortie s et est adapté à fournir, sur ce noeud s, une tension VIREVLIMB changeant de niveau lorsque le courant appliqué sur son noeud d'entrée e- atteint un niveau sensiblement égal à celui du courant appliqué sur son noeud d'entrée e+. Le comparateur de courant ICMP comprend en outre un noeud d'alimentation p relié au noeud 305 de fourniture de la tension d'alimentation interne VMAX_INT. La réalisation du circuit de comparaison de courant ICMP n'a pas été détaillée, les modes de réalisation décrits étant compatibles avec tous ou la plupart des circuits de comparaison de courant connus.

Le circuit de contrôle 301 de la figure 3 comprend en outre un comparateur de tension VCMP dont un premier noeud d'entrée e- est relié d'une part au noeud 101 d'application de la tension d'alimentation d'entrée VDD1 par l'intermédiaire d'un interrupteur K3, et d'autre part au noeud 103 d'application de la tension d'alimentation d'entrée VDD2 par l'intermédiaire d'un interrupteur K4, et dont un deuxième noeud d'entrée e+ est relié au noeud 102 de fourniture de la tension VCORE. Le comparateur de tension VCMP comprend un noeud de sortie s et est adapté à fournir, sur ce noeud s, une tension VCOVVDD changeant de niveau lorsque la tension appliquée sur son noeud d'entrée e+ atteint un niveau sensiblement égal à celui de la tension appliquée sur son noeud d'entrée e-. Le comparateur de tension VCMP comprend en outre un noeud d'alimentation p relié au noeud 305 de fourniture de la tension d'alimentation interne VMAX_INT. La réalisation du circuit de comparaison de tension VCMP n'a pas été détaillée, les modes de réalisation décrits étant compatibles avec tous ou la plupart des circuits de comparaison de tension connus.

Dans cet exemple, le circuit de contrôle 301 comprend de plus un circuit de séquencement asynchrone (sans horloge) FSM, mettant par exemple en oeuvre une machine à états finis. Le circuit de séquencement FSM comporte :
un noeud de sortie s1 relié au noeud d'entrée e2 du générateur de rampe RMP et adapté à fournir le signal de commande CTRLDW ;
un noeud de sortie s2 relié au noeud d'entrée e1 du générateur de rampe RMP et adapté à fournir le signal de commande CTRLUP ;
un noeud de sortie s3 relié au noeud d'entrée e3 du circuit de régulation linéaire LDO1 et adapté à fournir le signal de commande SWON1 ;
un noeud de sortie s4 relié au noeud d'entrée e2 du circuit de régulation linéaire LDO1 et adapté à fournir le signal de commande SWOFF1 ;
un noeud de sortie s5 relié au noeud d'entrée e3 du circuit de régulation linéaire LDO2 et adapté à fournir le signal de commande SWON2 ;
un noeud de sortie s6 relié au noeud d'entrée e2 du circuit de régulation linéaire LDO2 et adapté à fournir le signal de commande SWOFF2 ;
un noeud de sortie s7 relié au noeud d'entrée e4 du circuit de régulation linéaire LDO2 et adapté à fournir le signal de commande EN_LDO2 ;
un noeud de sortie s8 relié au noeud d'entrée e4 du circuit de régulation linéaire LDO1 et adapté à fournir le signal de commande EN_LDO1 ;
un noeud de sortie s9 relié au noeud d'entrée e1 du circuit à retard DEL et adapté à fournir le signal de commande TRLOORHI ;
un noeud de sortie s10 relié à la grille du transistor SWPG1 et adapté à fournir une tension EN SWPG1 de commande à l'état ouvert ou à l'état fermé du transistor SWPG1 ;
un noeud de sortie s11 relié à la grille du transistor SWPG2 et adapté à fournir une tension EN_SWPG2 de commande à l'état ouvert ou à l'état fermé du transistor SWPG2 ;
un noeud de sortie s12 relié à la grille du transistor SWPGVMAX et adapté à fournir une tension EN_SWPGVMAX de commande à l'état ouvert ou à l'état fermé du transistor SWPGVMAX ;
un noeud d'entrée e1 relié au noeud de sortie s du comparateur de tension VCMP et adapté à recevoir la tension de sortie VCOVVDD du comparateur VCMP ;
un noeud d'entrée e2 relié au noeud de sortie s du circuit à retard DEL et adapté à recevoir la tension de sortie TRLOORHI_DEL du circuit DEL ; et
un noeud d'entrée e3 relié au noeud de sortie s du comparateur de courant ICMP et adapté à recevoir la tension de sortie VIREVLIMB du comparateur ICMP.

Dans l'exemple représenté, le circuit de séquencement FSM comprend en outre une entrée de commande 310 sur un ou plusieurs bits (DIGBUS[1:x]) permettant de commander le circuit de sélection de tension dans la première configuration (transistors SW1 et SW2 respectivement fermé et ouvert) ou dans la deuxième configuration (transistors SW1 et SW2 respectivement ouvert et fermé), et, le cas échéant, de configurer certains paramètres du circuit 301. Le circuit de séquencement FSM comprend en outre un noeud d'alimentation p1 relié au noeud 303 de fourniture de la tension VMAX. Dans cet exemple, le circuit de séquencement FSM comprend en outre un noeud d'alimentation p2 relié au noeud 312 d'application de la tension VANA. La réalisation du circuit de séquencement FSM n'a pas été détaillée, la réalisation d'un tel circuit étant à la portée de l'homme du métier à partir des indications fonctionnelles décrites dans la présente demande.

Les figures 4 et 5 sont des chronogrammes illustrant schématiquement un exemple d'un mode de fonctionnement du circuit de sélection de tension d'alimentation de la figure 3.

Dans cet exemple, on considère que la tension d'alimentation d'entrée VDD1 est supérieure à la tension d'alimentation d'entrée VDD2. Dans cette configuration, pendant les phases de transition du circuit de sélection, les interrupteurs K1 et K2 sont maintenus respectivement ouvert (bloqué) et fermé (passant), de façon à relier le noeud d'entrée e+ du comparateur de courant ICMP au noeud 308 de fourniture du courant IREP2, et les interrupteurs K3 et K4 sont maintenus respectivement ouvert et fermé, de façon à relier le noeud d'entrée e- du comparateur de tension VCMP au noeud 103 d'application de la tension VDD2.

La figure 4 illustre le fonctionnement du circuit lors d'une phase de transition descendante, c'est-à-dire lors d'une phase de transition de la première configuration (transistors SW1 et SW2 respectivement fermé et ouvert) à la deuxième configuration (transistors SW1 et SW2 respectivement ouvert et fermé). La figure 4 représente plus particulièrement l'évolution, en fonction du temps, des signaux EN_SWPG2, EN_SWPG1, EN_SWPGVMAX, EN_LDO1, CTRL_DW, SWON2, SWON1, SWOFF1, SWOFF2, VCOVVDD, TRLOORHI, TRLOORHI_DEL et VCORE du circuit lors d'une phase de transition descendante. La figure 4 représente en outre l'évolution, en fonction du temps, d'un signal TR START de commande d'une transition du circuit de sélection entre les première et deuxième configurations. Dans cet exemple, on considère que les signaux TR_START, EN_SWPG2, EN_SWPG1, EN_SWPGVMAX, EN_LDO1, CTRLDW, SWON2, SWON1, SWOFF1, SWOFF2, VCOVVDD, TRLOORHI, TRLOORHI_DEL sont des signaux binaires pouvant prendre chacun soit un état haut, soit un état bas (c'est-à-dire inférieur à l'état haut).

Avant le début de la phase de transition descendante, le circuit de sélection est dans la première configuration (transistors SW1 et SW2 respectivement fermé et ouvert). Dans cette configuration, le signal TR_START est à l'état bas, le signal EN_SWPG2 est à l'état bas de façon à maintenir le transistor SWPG2 ouvert, le signal EN_SWPG1 est à l'état haut de façon à maintenir le transistor SWPG1 fermé, le signal EN_SWPGVMAX est à l'état haut de façon à maintenir le transistor SWPGVMAW fermé, le signal EN_LDO1 est à l'état bas de façon à désactiver la fonction de régulation linéaire du circuit LDO1, le signal CTRLDW est à l'état bas, les signaux SWON1 et SWOFF1 sont respectivement à l'état haut et à l'état bas de façon à forcer le maintien à l'état fermé du transistor SW1 par le circuit LDO1, les signaux SWON2 et SWOFF2 sont respectivement à l'état bas et à l'état haut de façon à forcer le maintien à l'état ouvert du transistor SW2 par le circuit LDO2, le signal VCOVVDD de sortie du comparateur VCMP est à l'état haut, les signaux TRLOORHI d'entrée et TRLOORHI_DEL de sortie du circuit à retard DEL sont à l'état bas, et la tension VCORE est sensiblement égale à la tension VDD1.

A un instant t0 de début d'une phase de transition descendante, le signal TR_START passe à l'état haut. A cet instant, le signal EN_SWPG2 est mis à l'état haut de façon à fermer le transistor SWPG2. De plus, le signal EN_LDO1 est mis à l'état haut de façon à activer la fonction de régulation linéaire du circuit LDO1, et le signal SWON1 est mis à l'état bas de façon à cesser de forcer le maintien à l'état fermé du transistor SW1 par le circuit LDO1. En outre, le signal CTRLDW est mis à l'état haut, de façon à commander la fourniture d'une rampe de tension décroissante par le circuit de génération de rampes RMP. Le circuit RMP génère alors sur son noeud de sortie s une tension VCTRL décroissant de façon continue de la valeur VDD1 à la valeur VDD2 selon une rampe prédéterminée. Cette tension VTCRL est appliquée sur l'entrée de consigne e5 du circuit de régulation linéaire LDO1. Le circuit LDO1 régule alors le signal de commande appliqué sur la grille du transistor SW1 de façon à reproduire la tension de consigne VCTRL sur le noeud 102. La tension VCORE décroit ainsi de façon continue, par exemple linéairement, de la valeur VDD1 à la valeur VDD2, en suivant sensiblement la pente de consigne générée par le circuit RMP.

A un instant t1 postérieur à l'instant t0, la tension VCORE atteint le niveau VDD2, ce qui provoque un changement d'état (passage à l'état bas dans cet exemple) de la tension de sortie VCOVVDD du comparateur de tension VCMP. Ce changement d'état du signal VCOVVDD est détecté par le circuit de séquencement FSM, et marque la fin de la phase de transition descendante. Le signal EN_LDO1 est alors mis à l'état bas de façon à interrompre la fonction de régulation linéaire mise en oeuvre par le circuit LDO1, et le signal SWOFF1 est mis à l'état haut de façon à commander l'ouverture du transistor SW1 par le circuit LDO1. De plus, les signaux SWON2 et SWOFF2 sont mis respectivement à l'état haut et à l'état bas, de façon à commander la fermeture du transistor SW2 par le circuit LDO2. En outre, le signal EN_SWPG1 est mis à l'état bas, de façon à commander l'ouverture du transistor SWPG1. Le signal CTRLDW est par ailleurs remis à l'état bas. A titre d'exemple, la durée T_{dw} = t1-t0 de la transition descendante, correspondant sensiblement au temps mis par la rampe de tension VCTRL pour passer de la valeur VDD1 à la valeur VDD2, est fixée à une valeur comprise entre 10 ns et 1 ms, par exemple de l'ordre de 100 ns.

La figure 5 illustre le fonctionnement du circuit lors d'une phase de transition montante, c'est-à-dire lors d'une phase de transition de la deuxième configuration (transistors SW1 et SW2 respectivement ouvert et fermé) à la première configuration (transistors SW1 et SW2 respectivement fermé et ouvert). La figure 5 représente plus particulièrement l'évolution, en fonction du temps, des signaux TR_START, EN_SWPG1, EN_SWPG2, EN_SWPGVMAX, EN_LDO1, CTRLUP, SWON1, SWOFF1, SWOFF2, SWON2, VIREVLIMB, TRLOORHI, TRLOORHI_DEL et VCORE du circuit lors d'une phase de transition montante. Comme dans l'exemple de la figure 4, on considère que les signaux TR_START, EN_SWPG1, EN_SWPG2, EN_SWPGVMAX, EN_LDO1, CTRLUP, SWON1, SWOFF1, SWOFF2, SWON2, VIREVLIMB, TRLOORHI, TRLOORHI_DEL sont des signaux binaires pouvant prendre chacun soit un état haut soit un état bas.

Avant le début de la phase de transition montante, le circuit de sélection est dans la deuxième configuration (transistors SW1 et SW2 respectivement ouvert et fermé). Dans cette configuration, le signal TR_START est à l'état bas, le signal EN SWPG1 est à l'état bas de façon à maintenir le transistor SWPG1 ouvert, le signal EN_SWPG2 est à l'état haut de façon à maintenir le transistor SWPG2 fermé, le signal EN_SWPGVMAX est à l'état haut de façon à maintenir le transistor SWPGVMAW fermé, le signal EN_LDO1 est à l'état bas de façon à désactiver la fonction de régulation linéaire du circuit LDO1, le signal CTRLUP est à l'état bas, les signaux SWON1 et SWOFF1 sont respectivement à l'état bas et à l'état haut de façon à forcer le maintien à l'état ouvert du transistor SW1 par le circuit LDO1, les signaux SWON2 et SWOFF2 sont respectivement à l'état haut et à l'état bas de façon à forcer le maintien à l'état fermé du transistor SW2 par le circuit LDO2, le signal VIREVLIMB de sortie du comparateur ICMP est à l'état haut, les signaux TRLOORHI d'entrée et TRLOORHI_DEL de sortie du circuit à retard DEL sont à l'état bas, et la tension VCORE est sensiblement égale à la tension VDD2.

A un instant t0 de début d'une phase de transition montante, le signal TR_START passe à l'état haut. A cet instant, le signal EN_SWPG1 est mis à l'état haut de façon à fermer le transistor SWPG1. De plus, le signal EN_LDO1 est mis à l'état haut de façon à activer la fonction de régulation linéaire du circuit LDO1, et le signal SWOFF1 est mis à l'état bas de façon à cesser de forcer le maintien à l'état ouvert du transistor SW1 par le circuit LDO1. En outre, le signal CTRLUP est mis à l'état haut, de façon à commander la fourniture d'une rampe de tension croissante par le circuit de génération de rampes RMP. Le circuit RMP génère alors sur son noeud de sortie s une tension VCTRL croissant de façon continue de la valeur VDD2 à la valeur VDD1 selon une rampe prédéterminée. Cette tension VTCRL est appliquée sur l'entrée de consigne e5 du circuit de régulation linéaire LDO1. Le circuit LDO1 régule alors le signal de commande appliqué sur la grille du transistor SW1 de façon à reproduire la tension de consigne VCTRL sur le noeud 102. La tension VCORE croit ainsi de façon continue, par exemple linéairement, de la valeur VDD2 à la valeur VDD1, en suivant sensiblement la pente de consigne générée par le circuit RMP. A l'instant t0, l'état du signal TRLOORHI est en outre modifié (mis à l'état haut dans cet exemple), de façon à déclencher la génération d'un retard par le circuit DEL.

A un instant t1 postérieur à l'instant t0, la tension VCORE atteint un niveau tel que le courant circulant dans le transistor SW2 tend à s'inverser. Cette inversion est détectée par le circuit de comparaison de courant ICMP, qui compare un courant IREP2 proportionnel au courant circulant dans le transistor SW2 à un courant de référence IREVLIM, par exemple nul ou proche de zéro, par exemple compris entre 0 et 10 mA. L'instant t1 correspond dans cet exemple à l'instant de changement d'état de la tension de sortie VIREVLIMB du comparateur de courant ICMP, lorsque le courant IREP2 atteint le niveau IREVLIM. Ce changement d'état est détecté par le circuit de séquencement FSM. Les signaux SWON2 et SWOFF2 sont alors mis respectivement à l'état bas et à l'état haut de façon à commander l'ouverture du transistor SW2 par le circuit LDO2. De plus, le signal EN_SWPG2 est mis à l'état bas de façon à ouvrir le transistor SWPG2.

A un instant t2 postérieur à l'instant t1, le délai généré par le circuit à retard DEL expire, c'est-à-dire que le signal TRLOORHI_DEL change d'état (passe à l'état haut dans cet exemple). La durée t2-t0 est une durée prédéterminée fixée par le circuit à retard DEL. Cette durée est choisie au moins égale au temps mis par la rampe de tension VCTRL générée par le circuit RMP pour passer de la valeur VDD2 à la valeur VDD1. Ainsi, à l'instant t2, la tension VCORE est sensiblement égale à la tension VDD1. L'instant t2 marque la fin de la phase de transition montante. Le changement d'état du signal TRLOORHI_DEL est détecté par le circuit de séquencement FSM. Le signal EN_LDO1 est alors mis à l'état bas pour interrompre la fonction de régulation linéaire mise en oeuvre par le circuit LDO1, et le signal SWON1 est mis à l'état haut de façon à commander la fermeture du transistor SW1 par le circuit LDO1. Les signaux CTRLUP, TRLOORHI et TRLOORHI_DEL peuvent en outre être remis à l'état bas dans l'attente d'une nouvelle transition descendante. A titre d'exemple, la durée Tᵤₚ = t2-t0 de la transition montante, fixée par le circuit à retard DEL et correspondant sensiblement au temps mis par la rampe de tension VCTRL pour passer de la valeur VDD2 à la valeur VDD1, est fixée à une valeur comprise entre 10 ns et 1 ms, par exemple de l'ordre de 100 ns.

Un avantage du circuit de la figure 3 est qu'il permet de contrôler les variations de la tension VCORE pendant les phases de transition entre les première et deuxième configurations du circuit de sélection de tension.

En outre, le circuit de la figure 3 permet de maitriser le courant inverse susceptible de circuler dans le transistor SW2 lors des phases de transition descendante.

De plus, dans le circuit de la figure 3, le contrôle des transitions entre les première et deuxième configurations est réalisé de manière asynchrone, et ne nécessite pas de signal d'horloge.

En outre, le circuit de la figure 3 présente une consommation électrique et un encombrement relativement faibles.

L'architecture de la figure 3 peut aisément être répétée, par exemple en plusieurs régions d'une puce de circuit intégré, de façon à réaliser une alimentation distribuée commutable entre les deux niveaux VDD1 et VDD2.

De plus, l'architecture de la figure 3 peut aisément être adaptée pour augmenter le nombre de tensions d'alimentation d'entrée, c'est-à-dire pour réaliser un circuit permettant de sélectionner une tension d'alimentation VCORE parmi un nombre de tensions d'alimentation d'entrée VDDi supérieur à 2.

Un autre avantage du circuit de la figure 3 est que son comportement pendant les phases de transition entre les première et deuxième configurations est indépendant du courant de charge tiré par le circuit charge sur le noeud 102.

De plus, le circuit de la figure 3 ne génère pas d'ondulations de la tension VCORE sur le noeud 102 pendant les phases de transition.

La figure 6 est un schéma électrique d'un exemple de réalisation du circuit de régulation linéaire de tension LDO1 du circuit de la figure 3. Sur la figure 6, on a représenté, outre le circuit LDO1, le transistor de puissance SW1, ainsi que les noeuds 101 (VDD1), 102 (VCORE) et 304 (VSS) du circuit de sélection de tension.

Le circuit LDO1 de la figure 6 comprend un circuit de polarisation (BIAS) dont un noeud d'alimentation haute p+ est connecté au noeud d'alimentation p du circuit LDO1 et dont un noeud d'alimentation basse p- est connecté au noeud 304 (VSS) correspondant à la masse du circuit. Le circuit de polarisation BIAS comprend un noeud s1 de fourniture d'une tension de polarisation BIASP, un noeud s2 de fourniture d'une tension de polarisation VB, et un noeud s3 de fourniture d'une tension de polarisation BIASN. Le circuit LDO1 comprend en outre un transistor MOS 601 reliant, via ses noeuds de conduction, le noeud d'alimentation p du circuit LDO1 au noeud de sortie s1 du circuit de polarisation BIAS, et un transistor MOS 603 reliant, via ses noeuds de conduction, le noeud de sortie s3 du circuit de polarisation BIAS au noeud 304. Dans cet exemple, le transistor 601 est un transistor MOS à canal P dont la source est connectée au noeud p et dont le drain est connecté au noeud s1, et le transistor 603 est un transistor MOS à canal N dont la source est connectée au noeud 304 et dont le drain est connecté au noeud s3. La grille du transistor 601 est connectée au noeud e4 d'application du signal de commande d'activation EN_LDO1 du circuit LDO1, et la grille du transistor 603 est reliée au même noeud e4 mais par l'intermédiaire d'un inverseur 605, de façon que les transistors 601 et 603 soient commandés simultanément à l'état ouvert ou simultanément à l'état fermé selon l'état du signal EN LDO1. Le circuit LDO1 de la figure 6 comprend en outre un transistor MOS MPBIAS reliant, via ses noeuds de conduction, le noeud d'alimentation p du circuit LDO1 à son noeud de sortie s, c'est-à-dire à la grille du transistor SW1. Dans cet exemple, le transistor MPBIAS est un transistor MOS à canal P dont la source est connectée au noeud p et dont le drain est connecté au noeud s. La grille du transistor MPBIAS est connectée au noeud de sortie s1 du circuit BIAS. Le circuit LDO1 comprend en outre un transistor MOS MNVB reliant, via ses noeuds de conduction, le noeud de sortie s du circuit LDO1 à un noeud intermédiaire n1, et un transistor MOS MNBIAS reliant, via ses noeuds de conduction, le noeud n1 au noeud 304. Dans cet exemple, les transistors MNVB et MNBIAS sont des transistors MOS à canal N. Le drain et la source du transistor MNVB sont connectés respectivement au noeud s et au noeud n1, et le drain et la source du transistor MNBIAS sont connectés respectivement au noeud n1 et au noeud 304. La grille du transistor MNVB est connectée au noeud de sortie s2 du circuit BIAS, et la grille du transistor MNBIAS est connectée au noeud de sortie s3 du circuit BIAS. Le circuit LDO1 de la figure 6 comprend de plus un transistor MOS MPREG reliant, via ses noeuds de conduction, le noeud d'entrée e1 du circuit LDO1, c'est-à-dire le noeud 102 de fourniture de la tension VCORE, au noeud interne n1. Dans cet exemple, le transistor MPREG est un transistor MOS à canal P dont la source est connectée au noeud e1 et dont le drain est connecté au noeud n1. La grille du transistor MPREG est connectée au noeud e5 d'application de la tension de consigne VCTRL. Dans cet exemple, le circuit LDO1 comprend en outre un transistor MOS MPDIS relié en série, via ses noeuds de conduction, avec une résistance RDISLIM, entre le noeud d'entrée e1 du circuit LDO1 et le noeud 304. Dans cet exemple, le transistor MPDIS est un transistor MOS à canal P dont la source est connectée au noeud e1 et dont le drain est connecté à une première extrémité de la résistance RDISLIM, la deuxième extrémité de la résistance RDISLIM étant connectée au noeud 304. La grille du transistor MPDIS est connectée au noeud e5 d'application de la tension de consigne VCTRL. Le circuit LDO1 de la figure 6 comprend de plus un transistor MOS MPOFF reliant, via ses noeuds de conduction, le noeud d'alimentation p du circuit LDO1 à son noeud de sortie s, et un transistor MOS MPON reliant, via ses noeuds de conduction, le noeud 304 au noeud s. Dans cet exemple, les transistors MPOFF et MPON sont respectivement un transistor MOS à canal P et un transistor MOS à canal N. La source et le drain du transistor MPOFF sont respectivement connectés au noeud p et au noeud s, et la source et le drain du transistor MNON sont respectivement connectés au noeud 304 et au noeud s. La grille du transistor MNON est connectée au noeud e3 d'application du signal de commande SWON1, et la grille du transistor MPOFF est reliée au noeud e2 d'application du signal de commande SWOFF1 par l'intermédiaire d'un inverseur 607.

La figure 7 est un schéma électrique d'un autre exemple de réalisation d'un circuit de régulation linéaire de tension LDO1 du circuit de la figure 3. Comme sur la figure 6, on a représenté, outre le circuit LDO1, le transistor de puissance SW1, ainsi que les noeuds 101 (VDD1), 102 (VCORE) et 304 (VSS) du circuit de sélection de tension.

Le circuit LDO1 de la figure 7 comprend un circuit de polarisation (BIAS) dont un noeud d'alimentation haute p+ est connecté au noeud d'alimentation p du circuit LDO1 et dont un noeud d'alimentation basse p- est connecté au noeud 304 (VSS) correspondant à la masse du circuit. Le circuit de polarisation BIAS comprend un noeud s1 de fourniture d'une tension de polarisation BIASN. Le circuit LDO1 comprend en outre un transistor MOS 701 reliant, via ses noeuds de conduction, le noeud d'alimentation p du circuit LDO1 à un noeud interne o1, et un transistor MOS 703 reliant, via ses noeuds de conduction, le noeud de sortie s1 du circuit de polarisation BIAS au noeud 304. Dans cet exemple, le transistor 701 est un transistor MOS à canal P dont la source est connectée au noeud p et dont le drain est connecté au noeud o1, et le transistor 703 est un transistor MOS à canal N dont la source est connectée au noeud 304 et dont le drain est connecté au noeud s1. La grille du transistor 701 est connectée au noeud e4 d'application du signal de commande d'activation EN_LDO1 du circuit LDO1, et la grille du transistor 703 est reliée au même noeud e4 mais par l'intermédiaire d'un inverseur 705, de façon que les transistors 701 et 703 soient commandés simultanément à l'état ouvert ou simultanément à l'état fermé, selon l'état du signal EN_LDO1. Le circuit LDO1 de la figure 7 comprend en outre un transistor MOS MPL1 reliant, via ses noeuds de conduction, le noeud d'alimentation p du circuit LDO1 à son noeud de sortie s, c'est-à-dire à la grille du transistor SW1. Dans cet exemple, le transistor MPL1 est un transistor MOS à canal P dont la source est connectée au noeud p et dont le drain est connecté au noeud s. La grille du transistor MPL1 est connectée au noeud o1. Le circuit LDO1 comprend en outre un transistor MOS MND1 reliant, via ses noeuds de conduction, le noeud de sortie s du circuit LDO1 à un noeud intermédiaire o2, et un transistor MOS MNBIAS reliant, via ses noeuds de conduction, le noeud o2 au noeud 304. Dans cet exemple, les transistors MND1 et MNBIAS sont des transistors MOS à canal N. Le drain et la source du transistor MND1 sont connectés respectivement au noeud s et au noeud o2, et le drain et la source du transistor MNBIAS sont connectés respectivement au noeud o2 et au noeud 304. La grille du transistor MND1 est connectée au noeud e5 d'application de la tension de consigne VCTRL, et la grille du transistor MNBIAS est connectée au noeud de sortie s1 du circuit BIAS. Le circuit LDO1 de la figure 7 comprend de plus un transistor MOS MPL2 reliant, via ses noeuds de conduction, le noeud d'alimentation p du circuit LDO1 au noeud o1, et un transistor MOS MND2 reliant, via ses noeuds de conduction, le noeud o1 au noeud o2. Dans cet exemple, les transistors MPL2 et MND2 sont respectivement un transistor MOS à canal P et un transistor MOS à canal N. Le drain et la source du transistor MPL2 sont connectés respectivement au noeud o1 et au noeud p, et le drain et la source du transistor MND2 sont connectés respectivement au noeud o1 et au noeud o2. La grille du transistor MPL2 est connectée au noeud o1, et la grille du transistor MND2 est connectée au noeud d'entrée e1 du circuit LDO1, c'est-à-dire au noeud 102 de fourniture de la tension VCORE. Le circuit LDO1 de la figure 7 comprend en outre un transistor MOS MPOFF reliant, via ses noeuds de conduction, le noeud d'alimentation p du circuit LDO1 à son noeud de sortie s, et un transistor MOS MPON reliant, via ses noeuds de conduction, le noeud 304 au noeud s. Dans cet exemple, les transistors MPOFF et MPON sont respectivement un transistor MOS à canal P et un transistor MOS à canal N. La source et le drain du transistor MPOFF sont respectivement connectés au noeud p et au noeud s, et la source et le drain du transistor MNON sont respectivement connectés au noeud 304 et au noeud s. La grille du transistor MNON est connectée au noeud e3 d'application du signal de commande SWON1, et la grille du transistor MPOFF est reliée au noeud e2 d'application du signal de commande SWOFF1 par l'intermédiaire d'un inverseur 707. Le circuit de régulation LDO1 de la figure 7 comprend en outre un transistor MOS MNBIAS2 reliant, via ses noeuds de conduction, le noeud e1 au noeud 304. Dans cet exemple, le transistor MNBIAS2 est un transistor MOS à canal N dont la source et le drain sont connectés respectivement au noeud 304 et au noeud e1. La grille du transistor MNBIAS2 est connectée au noeud de sortie s1 du circuit de polarisation BIAS. Le circuit LDO1 de la figure 7 comprend de plus un condensateur CM dont une première électrode est reliée au noeud s et dont la deuxième électrode est reliée au noeud e1.

Des modes de réalisation particuliers ont été décrits. Diverses variantes et modifications apparaîtront à l'homme de l'art. En particulier, le circuit de la figure 3 peut être simplifié si l'on sait à l'avance laquelle des tensions d'alimentation d'entrée VDD1 et VDD2 est la plus élevée. Par exemple, si l'on sait à l'avance que la tension VDD1 est supérieure à la tension VDD2, le circuit de régulation linéaire LDO2 peut être omis, le transistor SW2 n'étant alors commandé qu'à l'état ouvert ou à l'état fermé. En outre, le transistor SW1_REP de mesure du courant circulant dans le transistor SW1 peut être omis. De plus, les interrupteurs K1, K2, K3, K4 peuvent être supprimés, les noeuds d'entrée e- du comparateur ICMP et e- du comparateur VCMP étant alors reliés directement respectivement au noeud 308 de fourniture du courant IREP2 et au noeud 103 d'application de la tension VDD2. En outre, les noeuds 303 et 101 peuvent être confondus.

De plus, dans le circuit décrit en relation avec la figure 3, le circuit formé par les transistors SW1_REP et SW2_REP et par le comparateur de courant ICMP peut être remplacé par tout autre circuit adapté à détecter une inversion du courant circulant dans le transistor SW2 ou dans le transistor SW1.

Par ailleurs, alternativement à l'utilisation du circuit à retard DEL pour détecter la fin des transitions montantes, on peut prévoir de réaliser une comparaison de la tension VCORE fournie par le noeud 102 à la plus élevée des tensions d'alimentation VDD1 et VDD2, par exemple en utilisant le comparateur de tension VCMP.

De plus, les transistors de limitation des fuites SWPG1, SWPG2, SWPGMAX peuvent être omis. Dans ce cas, les sources des transistors SW1, respectivement SW2, peuvent être connectées directement aux noeuds 101, respectivement 103, et les noeuds 305 et 303 peuvent être confondus.

## Revendications

1. Circuit de sélection d'une tension d'alimentation, comprenant :
des premier (101) et deuxième (103) noeuds adaptés à recevoir respectivement une première tension d'alimentation d'entrée (VDD1) et une deuxième tension d'alimentation d'entrée (VDD2) inférieure à la première tension ;
un troisième noeud (102) adapté à fournir une tension d'alimentation de sortie (VCORE) ;
un premier transistor MOS de puissance (SW1) reliant le premier noeud (101) au troisième noeud (102) ;
un deuxième transistor MOS de puissance (SW2) reliant le deuxième noeud (103) au troisième noeud (102) ; et
un circuit de contrôle (301) adapté, dans une première configuration, à maintenir les premier (SW1) et deuxième (SW2) transistors respectivement fermé et ouvert de façon à appliquer la première tension d'alimentation d'entrée (VDD1) sur le troisième noeud (102), et, dans une deuxième configuration, à maintenir les premier (SW1) et deuxième (SW2) transistors respectivement ouvert et fermé de façon à appliquer la deuxième tension d'alimentation d'entrée (VDD2) sur le troisième noeud (102),
le circuit de contrôle (301) comportant une boucle de rétroaction du troisième noeud (102) vers la grille du premier transistor (SW1), et étant adapté, lors d'une phase de transition de la première à la deuxième configuration ou de la deuxième à la première configuration, à commander le premier transistor (SW1) en régime linéaire pour appliquer une rampe de tension continue sur le troisième noeud (102),
dans lequel le circuit de contrôle (301) comprend :
un générateur de rampes de tension (RMP) ; et
un premier circuit de régulation linéaire (LDO1) formant la boucle de rétroaction, et dont un premier noeud d'entrée (e1) est connecté au troisième noeud (102), dont un deuxième noeud d'entrée (e5) est connecté à un noeud de sortie (s) du générateur de rampes (RMP), et dont un noeud de sortie (s) est connecté à la grille du premier transistor (SW1),
et dans lequel le premier circuit de régulation linéaire (LDO1) est adapté à ajuster un signal de commande appliqué, via son noeud de sortie (s), sur la grille du premier transistor (SW1), de façon à asservir la tension de sortie (VCORE) sur une tension de consigne appliquée sur son deuxième noeud d'entrée (e5) .

2. Circuit de sélection selon la revendication 1, comportant en outre un deuxième circuit de régulation linéaire (LDO2) dont un premier noeud d'entrée (e1) est connecté au troisième noeud (102), dont un deuxième noeud d'entrée (e5) est connecté à un noeud de sortie (s) du générateur de rampes (RMP), et dont un noeud de sortie (s) est connecté à la grille du deuxième transistor (SW2).

3. Circuit de sélection selon la revendication 1 ou 2, comprenant en outre un circuit (SW2_REP, ICMP) de détection d'une inversion du courant circulant dans le deuxième transistor (SW2).

4. Circuit de sélection selon la revendication 3, dans lequel le circuit de détection comprend un transistor de mesure (SW2_REP) agencé pour être traversé par un courant de mesure (IREP2) proportionnel au courant traversant le deuxième transistor (SW2), et un comparateur de courant (ICMP) adapté à comparer ledit courant de mesure (IREP2) à un seuil (IREVLIM).

5. Circuit de sélection selon l'une quelconque des revendications 1 à 4, comprenant en outre un circuit (VCMP) de comparaison de la tension de sortie (VCORE) à un seuil.

6. Circuit de sélection selon l'une quelconque des revendications 1 à 5, comportant en outre un circuit (DEL) de génération d'un retard prédéterminé.

7. Circuit de sélection selon l'une quelconque des revendications 1 à 6, dans lequel le premier transistor MOS de puissance (SW1) est relié au premier noeud (101) par l'intermédiaire d'un premier transistor MOS supplémentaire (SWPG1) présentant des courants de fuite à l'état bloqué inférieurs à celui du premier transistor MOS de puissance (SW1), et dans lequel le deuxième transistor MOS de puissance (SW2) est relié au deuxième noeud (103) par l'intermédiaire d'un deuxième transistor MOS supplémentaire (SWPG2) présentant des courants de fuite à l'état bloqué inférieurs à celui du deuxième transistor MOS de puissance (SW2).

8. Circuit de sélection selon la revendication 7, dans lequel le circuit de contrôle (301) est adapté, dans une troisième configuration, à maintenir les premier (SW1) et deuxième (SW2) transistors MOS de puissance et les premier (SWPG1) et deuxième (SWPG2) transistors MOS supplémentaires à l'état ouvert.

9. Circuit de sélection selon l'une quelconque des revendications 1 à 8, dans lequel le circuit de contrôle (301) est adapté, lors d'une phase de transition entre les première et deuxième configurations, à :
commander le premier transistor (SW1) en régime linéaire pour appliquer une rampe de tension continue décroissante sur le troisième noeud (102) ;
détecter un passage de la tension de sortie (VCORE) à un niveau sensiblement égal à celui de la deuxième tension d'alimentation d'entrée (VDD2) ; et
lorsque la tension de sortie (VCORE) atteint un niveau sensiblement égal à celui de la deuxième tension d'alimentation d'entrée (VDD2), fermer le deuxième transistor MOS de puissance (SW2) et ouvrir le premier transistor MOS de puissance (SW1).

10. Circuit de sélection selon l'une quelconque des revendications 1 à 9, dans lequel le circuit de contrôle (301) est adapté, lors d'une phase de transition entre les deuxième et première configurations, à :
commander, le premier transistor (SW1) en régime linéaire pour appliquer une rampe de tension continue croissante sur le troisième noeud (102) ;
détecter une inversion du courant circulant dans le deuxième transistor (SW2) ;
lorsque le courant circulant dans le deuxième transistor (SW2) s'inverse, ouvrir le deuxième transistor (SW2) ; et
après un délai prédéterminé, fermer le premier transistor MOS de puissance (SW1).

## Patentansprüche

1. Schaltkreis zur Auswahl einer Versorgungsspannung, der Folgendes aufweist:
einen ersten (101) und einen zweiten (103) Knoten, die in der Lage sind, eine erste Eingangsversorgungsspannung (VDD1) bzw. eine zweite Eingangsversorgungsspannung (VDD2), die kleiner als die erste Spannung ist, zu empfangen
einen dritten Knoten (102), der in der Lage ist, eine Ausgangsversorgungsspannung (VCORE) zu liefern;
einen ersten MOS-Leistungstransistor (SW1), der den ersten Knoten (101) mit dem dritten Knoten (102) koppelt;
einen zweiten MOS-Leistungstransistor (SW2), der den zweiten Knoten (103) mit dem dritten Knoten (102) koppelt; und
eine Steuerschaltung (301), die in der Lage ist, in einer ersten Konfiguration den ersten (SW1) und den zweiten (SW2) Transistor geschlossen bzw. offen zu halten, um die erste Eingangsversorgungsspannung (VDD1) an den dritten Knoten (102) anzulegen, und in einer zweiten Konfiguration den ersten (SW1) und den zweiten (SW2) Transistor offen bzw. geschlossen zu halten, um die zweite Eingangsversorgungsspannung (VDD2) an den dritten Knoten (102) anzulegen,
wobei die Steuerschaltung (301) eine Rückkopplungsschleife von dem dritten Knoten (102) zu dem Gate des ersten Transistors (SW1) aufweist und in der Lage ist, während einer Phase des Übergangs von der ersten zu der zweiten Konfiguration oder von der zweiten zu der ersten Konfiguration den ersten Transistor (SW1) in einem linearen Betriebsbereich zu steuern, um eine Gleichspannungsrampe an den dritten Knoten (102) anzulegen,
wobei die Steuerschaltung (301) Folgendes aufweist:
einen Spannungsrampengenerator (RMP); und
eine erste lineare Regelschaltung (LDO1), die die Rückkopplungsschleife bildet und bei der ein erster Eingangsknoten (e1) mit dem dritten Knoten (102) verbunden ist, ein zweiter Eingangsknoten (e5) mit einem Ausgangsknoten (s) des Rampengenerators (RMP) verbunden ist, und ein Ausgangsknoten (s) mit dem Gate des ersten Transistors (SW1) verbunden ist,
und wobei die erste lineare Regelschaltung (LDO1) in der Lage ist, ein über ihren Ausgangsknoten (s) an das Gate des ersten Transistors (SW1) angelegtes Steuersignal einzustellen, um die Ausgangsspannung (VCORE) auf eine an ihren zweiten Eingangsknoten (e5) angelegte Zielspannung zu regeln.

2. Auswahlschaltkreis nach Anspruch 1, der ferner eine zweite lineare Regelschaltung (LDO2) umfasst, bei der ein erster Eingangsknoten (e1) mit dem dritten Knoten (102) verbunden ist, ein zweiter Eingangsknoten (e5) mit einem Ausgangsknoten (s) des Rampengenerators (RMP) verbunden ist, und ein Ausgangsknoten (s) mit dem Gate des zweiten Transistors (SW2) verbunden ist.

3. Auswahlschaltkreis nach Anspruch 1 oder 2, der ferner eine Schaltung (SW2_REP, ICMP) zum Erfassen einer Umkehr des durch den zweiten Transistor (SW2) fließenden Stroms aufweist.

4. Auswahlschaltkreis nach Anspruch 3, wobei die Erfassungsschaltung einen Messtransistor (SW2_REP), der so angeordnet ist, dass ein Messstrom (IREP2) dahindurch fließt, der proportional zu dem durch den zweiten Transistor (SW2) fließenden Strom ist, und einen Stromvergleicher (ICMP) aufweist, der in der Lage ist, den Messstrom (IREP2) mit einem Schwellenwert (IREVLIM) zu vergleichen.

5. Auswahlschaltkreis nach einem der Ansprüche 1 bis 4, der ferner eine Schaltung (VCMP) zum Vergleichen der Ausgangsspannung (VCORE) mit einem Schwellenwert aufweist.

6. Auswahlschaltkreis nach einem der Ansprüche 1 bis 5, der ferner eine Schaltung (DEL) zum Erzeugen einer vorgegebenen Verzögerung aufweist.

7. Auswahlschaltkreis nach einem der Ansprüche 1 bis 6, wobei der erste MOS-Leistungstransistor (SW1) mit dem ersten Knoten (101) über einen ersten zusätzlichen MOS-Transistor (SWPG1) gekoppelt ist, dessen Leckströme im Ruhezustand kleiner als die des ersten MOS-Leistungstransistors (SW1) sind, und wobei der zweite MOS-Leistungstransistor (SW2) mit dem zweiten Knoten (103) über einen zweiten zusätzlichen MOS-Transistor (SWPG2) gekoppelt ist, dessen Leckströme im Ruhezustand kleiner als die des zweiten MOS-Leistungstransistors (SW2) sind.

8. Auswahlschaltkreis nach Anspruch 7, wobei die Steuerschaltung (301) in einer dritten Konfiguration in der Lage ist, den ersten (SW1) und den zweiten (SW2) MOS-Leistungstransistor und den ersten (SWPG1) und den zweiten (SWPG2) zusätzlichen MOS-Transistor im offenen bzw. Aus-Zustand zu halten.

9. Auswahlschaltkreis nach einem der Ansprüche 1 bis 8, wobei die Steuerschaltung (301) während einer Phase des Übergangs zwischen der ersten und der zweiten Konfiguration in der Lage ist zum
Steuern des ersten Transistors (SW1) im linearen Betriebsbereich, um eine abnehmende Gleichspannungsrampe an den dritten Knoten (102) anzulegen;
Erfassen eines Durchgangs der Ausgangsspannung (VCORE) auf einen Pegel, der im Wesentlichen gleich dem der zweiten Eingangsversorgungsspannung (VDD2) ist; und
wenn die Ausgangsspannung (VCORE) einen Pegel erreicht, der im Wesentlichen gleich dem der zweiten Eingangsversorgungsspannung (VDD2) ist, Schließen bzw. Einschalten des zweiten MOS-Leistungstransistors (SW2) und Öffnen bzw. Ausschalten des ersten MOS-Leistungstransistors (SW1).

10. Auswahlschaltkreis nach einem der Ansprüche 1 bis 9, wobei die Steuerschaltung (301) während einer Übergangsphase zwischen der ersten und zweiten Konfiguration in der Lage ist zum
Steuern des ersten Transistors (SW1) im linearen Betriebsbereich, um eine ansteigende Gleichspannungsrampe an den dritten Knoten (102) anzulegen;
Erfassen einer Umkehr des durch den zweiten Transistor (SW2) fließenden Stroms;
wenn sich der durch den zweiten Transistor (SW2) fließende Strom umkehrt, Öffnen bzw. Ausschalten des zweiten Transistors (SW2); und
nach einer vorbestimmten Verzögerung, Schließen bzw. Einschalten des ersten MOS-Leistungstransistors (SW1).

## Claims

1. A power supply voltage selection circuit, comprising:
first (101) and second (103) nodes capable of respectively receiving a first input power supply voltage (VDD1) and a second input power supply voltage (VDD2) smaller than the first voltage;
a third node (102) capable of supplying an output power supply voltage (VCORE);
a first MOS power transistor (SW1) coupling the first node (101) to the third node (102);
a second MOS power transistor (SW2) coupling the second node (103) to the third node (102); and
a control circuit (301) capable, in a first configuration, of keeping the first (SW1) and second (SW2) transistors respectively on and off to apply the first input power supply voltage (VDD1) to the third node (102) and, in a second configuration, of keeping the first (SW1) and second (SW2) transistors respectively off and on to apply the second input power supply voltage (VDD2) to the third node (102),
the control circuit (301) comprising a feedback loop from the third node (102) to the gate of the first transistor (SW1), and being capable, during a phase of transition from the first to the second configuration or from the second to the first configuration, of controlling the first transistor (SW1) in linear operating region to apply a DC voltage ramp to the third node (102),
wherein the control circuit (301) comprises:
a voltage ramp generator (RMP); and
a first linear regulation circuit (LDO1) forming the feedback loop, and having a first input node (e1) connected to the third node (102), having a second input node (e5) connected to an output node (s) of the ramp generator (RMP), and having an output node (s) connected to the gate of the first transistor (SW1),
and wherein the first linear regulation circuit (LDO1) is capable of adjusting a control signal applied, via its output node (s), to the gate of the first transistor (SW1), to control the output voltage (VCORE) to a target voltage applied to its second input node (e5).

2. The selection circuit of claim 1, further comprising a second linear regulation circuit (LDO2) having a first input node (e1) connected to the third node (102), having a second input node (e5) connected to an output node (s) of the ramp generator (RMP), and having an output node (s) connected to the gate of the second transistor (SW2).

3. The selection circuit of claim 1 or 2, further comprising a circuit (SW2_REP, ICMP) for detecting a reversal of the current flowing through the second transistor (SW2).

4. The selection circuit of claim 3, wherein the detection circuit comprises a measurement transistor (SW2_REP) arranged to conduct a measurement current (IREP2) proportional to the current flowing through the second transistor (SW2), and a current comparator (ICMP) capable of comparing said measurement current (IREP2) with a threshold (IREVLIM).

5. The selection circuit of any of claims 1 to 4, further comprising a circuit (VCMP) for comparing the output voltage (VCORE) with a threshold.

6. The selection circuit of any of claims 1 to 5, further comprising a circuit (DEL) for generating a predetermined delay.

7. The selection circuit of any of claims 1 to 6, wherein the first MOS power transistor (SW1) is coupled to the first node (101) via a first additional MOS transistor (SWPG1) having off-state leakage currents smaller than that of the first MOS power transistor (SW1), and wherein the second MOS power transistor (SW2) is coupled to the second node (103) via a second additional MOS transistor (SWPG2) having off-state leakage currents smaller than that of the second MOS power transistor (SW2).

8. The selection circuit of claim 7, wherein the control circuit (301) is capable, in a third configuration, of keeping the first (SW1) and second (SW2) MOS power transistors and the first (SWPG1) and second (SWPG2) additional MOS transistors in the off state.

9. The selection circuit of any of claims 1 to 8, wherein the control circuit (301) is capable, during a phase of transition between the first and second configurations, of:
controlling the first transistor (SW1) in linear operating target to apply a decreasing DC voltage ramp onto the third node (102);
detecting a switching of the output voltage (VCORE) to a level substantially equal to that of the second input power supply voltage (VDD2); and
when the output voltage (VCORE) reaches a level substantially equal to that of the second input power supply voltage (VDD2), turning on the second MOS power transistor (SW2) and turning off the first MOS power transistor (SW1).

10. The selection circuit of any of claims 1 to 9, wherein the control circuit (301) is capable, during a phase of transition between the first and second configurations, of:
controlling the first transistor (SW1) in linear operating region to apply an increasing DC voltage ramp onto the third node (102);
detecting an inversion of the current flowing through the second transistor (SW2);
when the current flowing through the second transistor (SW2) reverses, turning off the second transistor (SW2); and
after a predetermined delay, turning on the first MOS power transistor (SW1).
